# EUROPÄISCHE PATENTSCHRIFT

(11) **EP 2 856 526 B1**
(45) Veröffentlichungstag und Bekanntmachung des Hinweises auf die Patenterteilung: **10.07.2019**
(21) Anmeldenummer: 13728134.1
(22) Anmeldetag: 31.05.2013
(51) Int. Cl.: H01L 35/26, H01L 35/34

(54) **VERFAHREN ZUR HERSTELLUNG EINES THERMOELEKTRISCHEN BAUELEMENTS**
PROCESS FOR PRODUCING A THERMOELECTRIC COMPONENT
PROCÉDÉ DE FABRICATION D'UN COMPOSANT THERMOÉLECTRIQUE

(30) Priorität: 04.06.2012 DE 102012104809
(43) Veröffentlichungstag der Anmeldung: 08.04.2015
(73) Patentinhaber: CPT Group GmbH, 30165 Hannover (DE)
(72) Erfinder: BRÜCK, Rolf, 51429 Bergisch Gladbach (DE); LIMBECK, Sigrid, 53804 Much (DE)
(86) Internationale Anmeldenummer: PCT/EP2013/061217
(87) Internationale Veröffentlichungsnummer: WO 2013/182479

(56) Entgegenhaltungen:
- US-A1- 2009 004 086
- LI D ET AL: "ELECTROSPINNING OF POLYMERIC AND CERAMIC NANOFIBERS AS UNIAXIALLY ALIGNED ARRAYS", NANO LETTERS, AMERICAN CHEMICAL SOCIETY, US, Bd. 3, Nr. 8, 7. August 2003 (2003-08-07), Seiten 1167-1171, XP008052133, ISSN: 1530-6984, DOI: 10.1021/NL0344256

## Beschreibung

Die vorliegende Erfindung betrifft ein Verfahren zur Herstellung eines thermoelektrischen Bauelements.

Thermoelektrische Module werden einzeln oder in einer Mehrzahl als thermoelektrischer Generator eingesetzt, der aus einem Temperaturpotential und dem daraus resultierenden Wärmestrom elektrische Energie erzeugt. Die Erzeugung der elektrischen Energie erfolgt aufgrund des sogenannten Seebeck-Effekts. Thermoelektrische Module sind aus elektrisch miteinander verschalteten p-dotierten und n-dotierten thermoelektrischen Bauelementen aufgebaut. Die thermoelektrischen Bauelemente weisen eine sogenannte Heißseite und eine gegenüberliegend angeordnete Kaltseite auf, über die sie jeweils elektrisch leitend wechselweise mit benachbart angeordneten weiteren thermoelektrischen Bauelementen verbunden sind. Die Heißseite ist dabei mit einer Wandung des thermoelektrischen Moduls wärmeleitend verbunden, die mit einem heißen Medium (z.B. Abgas) beaufschlagt wird. Entsprechend ist die Kaltseite des thermoelektrischen Bauelements mit einer anderen Wandung des thermoelektrischen Moduls wärmeleitend verbunden, die mit einem kalten Medium (z.B. Kühlwasser) beaufschlagt wird.

Thermoelektrische Generatoren kommen insbesondere in Kraftfahrzeugen, aber auch in anderen technischen Gebieten zum Einsatz, in denen ein Temperaturpotential durch die Anordnung von thermoelektrischen Generatoren zur Erzeugung elektrischer Energie ausgenutzt werden kann.

Thermoelektrische Bauelemente werden im Betrieb eines thermoelektrischen Generators Temperaturpotentialen ausgesetzt, so dass zwischen einer Heißseite und einer Kaltseite des thermoelektrischen Bauelements ein Wärmestrom zur Erzeugung elektrischer Energie strömt. Weiterhin sind die thermoelektrischen Bauelemente thermischen Wechselspannungen ausgesetzt, die aus wechselnden Temperaturbeträgen an der Heißseite und an der Kaltseite resultieren. Infolge dieser Belastung kann es zu einem Versagen des thermoelektrischen Bauelements kommen, so dass die Effektivität der Umwandlung von thermischer Energie in elektrische Energie zumindest vermindert wird.

Die US 2009/004086 A1 betrifft die Herstellung von Nanofasern oder Nanoröhrchen aus thermoelektrischem Werkstoff. Der thermoelektrische Werkstoff wird mit einem Stützmaterial vermischt, so dass ein Faden oder Röhrchen gesponnen werden kann. Der gesponnene Faden wird auf eine Trommel aufgerollt. Der Faden wird noch auf der Trommel abgelängt, so dass eine Vielzahl von parallel angeordneten Fäden erzeugbar sind.

Der Fachartikel "Electrospinning of Polymeric and Ceramic Nanofibers as Uniaxially Aligned Arrays"; aus Nano Letters, 2003, befasst sich mit der Herstellung von Nanofasern, u.a. auch aus keramischem Material. Es wird insbesondere ein Verfahren zur Herstellung von Fasern mit gleicher Ausrichtung beschrieben.

Aufgabe der vorliegenden Erfindung ist es demnach, die mit Bezug auf den Stand der Technik geschilderten Probleme zumindest teilweise zu lösen. Insbesondere soll ein Verfahren zur Herstellung eines thermoelektrischem Bauelements angegeben werden, durch das ein dauerfestes und thermischen Wechselspannungen gegenüber robustes thermoelektrisches Bauelement bereitgestellt werden kann.

Diese Aufgaben werden gelöst mit einem Verfahren zur Herstellung eines thermoelektrischen Bauelements gemäß den Merkmalen des Patentanspruchs 1.

Weitere vorteilhafte Ausgestaltungen der Erfindung sind in den abhängig formulierten Patentansprüchen angegeben. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen. Die Beschreibung insbesondere im Zusammenhang mit den Figuren erläutert die Erfindung weiter und führt ergänzende Ausführungsbeispiele der Erfindung an.

Das Verfahren wird insbesondere in der Reihenfolge a) bis d) nacheinander durchgeführt, wobei insbesondere Schritte a), b) und c) mehrfach und/oder parallel zueinander ausgeführt werden können. Insbesondere umfasst das Verfahren weitere Schritte dazwischen, z.B. zur Handhabung der Faser, der beschichteten Faser und/oder des Rings.

Die Faser weist insbesondere mindestens eine der folgenden Eigenschaften auf: langgestreckt, fadenartig, flexibel, Querschnitt bevorzugt rund, Länge bevorzugt mindestens 100-mal größer als Durchmesser der Faser, Durchmesser mindestens 0,5 Mikrometer, Durchmesser höchstens 5 Mikrometer. Insbesondere umfasst das Verfahren, dass genau eine, bevorzugt aber eine Vielzahl, Faser(n) zur Herstellung eines thermoelektrischen Bauelements verwendet wird.

Bevorzugt besteht die mindestens eine Faser aus einem nicht-thermoelektrischen Material und insbesondere aus einem keramischen Werkstoff. Dabei werden insbesondere die folgenden Werkstoffe vorgeschlagen, die einzeln oder auch in Kombination miteinander zur Anwendung gelangen können:
Aluminiumoxide, Zirkonoxide.

Insbesondere wird in Schritt b) ein thermoelektrischer Werkstoff eingesetzt, der zumindest einen der folgenden Werkstoffe aufweist:

| Typ: | Material: |
|---|---|
| V-VI | Bi₂Te₃ |
| IV-VI | PbTe |
| Zn₄Sb₃ | Zn₄Sb₃ |
| Silizide | p-MnSi_{1.73} |
| | n-Mg₂Si_{0,4}Sn_{0,6} |
| | Si_{0,80}Ge_{0,20} |
| | Si_{0,94}Ge_{0,06} |
| Skutterudit | CoSb3 |
| Halb-Heusler | TiNiSn |
| n/p-Klathrate | Ba₈Ga₁₆Ge₃₀ |
| Oxide | p-NaCo₂O₄ |
| Zintl-Phasen | p-Yb₁₄MnSb₁₁ |
| Th₃P₄ | La_{3-X}Te₄ |

Gemäß einer besonders vorteilhaften Ausgestaltung ist die mindestens eine Faser hinsichtlich mindestens einer Werkstoffeigenschaft auf den thermoelektrischen Werkstoff abgestimmt ausgeführt. Insbesondere entsprechen zumindest in einem Temperaturbereich von 150 °C bis 600 °C die Wärmeausdehnungskoeffizienten der Faser und des thermoelektrischen Werkstoffs einander und weichen bevorzugt um höchstens 10 %, insbesondere nur um höchstens 2 % voneinander ab.

Bevorzugt weist die mindestens eine Faser die folgenden Werkstoffeigenschaften auf:
- Der Werkstoff der Faser hat eine höhere Festigkeit als der thermoelektrische Werkstoff;
- Zugfestigkeit des Werkstoffes der Faser größer als 100 N/mm² [Newton pro Quadratmillimeter]
- Druckfestigkeit des Werkstoffes der Faser größer als 500 N/mm²

Das Beschichten der mindestens einen Faser mit dem thermoelektrischen Werkstoff erfolgt bevorzugt durch Abscheidung des thermoelektrischen Werkstoffs auf der Faser, z. B. mittels CVD- (chemical vapor deposition) oder PVD- (physical vapor deposition) Verfahren. Es sind aber auch andere Verfahren für den Schritt der Beschichtung anwendbar.

Bevorzugt wird die mindestens eine beschichtete Faser zu einem Ring mit einer Mittelachse gewickelt, so dass sich die mindestens eine beschichtete Faser um die Mittelachse herum windet. Insbesondere wird die mindestens eine Faser zusätzlich gefaltet. Insbesondere weist der Ring einen Innendurchmesser und einen Außendurchmesser auf. Insbesondere wird durch das Verfahren ein (zylindrisches) Scheibenelement hergestellt, dass also keinen Innendurchmesser aufweist (also ein Ring mit einem Innendurchmesser von 0 mm).

Das optional vorgeschlagene Verpressen des Rings bzw. der mindestens einen beschichteten Faser erfolgt insbesondere bei einer Temperatur von mindestens 250 °C [Grad Celsius], wobei bevorzugt ein Druck von mindestens 2 bar zur Herstellung eines Rings aufgewendet wird. Bevorzugt sind Temperaturen von mehr als 500 °C und Drücke von mindestens 2,5 bar.

Zwar kann zur Herstellung des thermoelektrischen Bauelements, neben dem thermoelektrischen Werkstoff zum Beschichten der Faser, auch weiterer thermoelektrischer Werkstoff, insbesondere in oder nach Schritt c) hinzugefügt werden, so dass das thermoelektrische Bauelement nicht ausschließlich aus (verpresster,) beschichteter Faser besteht, sondern zusätzlich thermoelektrischer Werkstoff den Ring bildet. Bevorzugt wird das thermoelektrische Bauelement, aber ausschließlich durch die mindestens eine beschichtete Faser gebildet.

Erfindungsgemäß weist das nach Schritt d) erzeugte thermoelektrische Bauelement eine erste Erstreckung entlang einer axialen Richtung auf und wird in einem Schritt d1) durch ein Trennverfahren (z.B. Sägen) in mehrere (mindestens zwei) Ringe mit jeweils einer kleineren zweiten Erstreckung in der axialen Richtung geteilt.

Insbesondere beträgt die erste Erstreckung mindestens 2 mm, bevorzugt mindestens 10 mm. Die zweite Erstreckung beträgt entsprechend mindestens 1,0 mm.

Es ist insbesondere auch möglich, nach Schritt c) einen Schritt c1) durchzuführen, in dem der in Schritt c) erzeugte Ring durch ein Trennverfahren in mehrere (mindestens zwei) Ringe geteilt wird. Entsprechend würden die so nach Schritt d) erzeugten thermoelektrischen Bauelemente dann nicht weiter getrennt werden. Insbesondere wird bei einem durch das Verfahren hergestellten Scheibenelement ein Innendurchmesser in einem weiteren Schritt eingebracht. Dieser Schritt schließt sich bevorzugt an den Schritt c), c1) oder d) an.

Insbesondere erstreckt sich die mindestens eine beschichtete Faser in einer Umfangsrichtung des hergestellten thermoelektrischen Bauelements über einen Winkelbereich von mindestens 120° [(Winkel-) Grad], bevorzugt von mindestens 360° und besonders bevorzugt von mindestens 420°. Insbesondere überlappen sich zumindest zwei beschichtete Fasern in Umfangsrichtung über einen Winkelbereich von mindestens 5°. Dadurch wird sichergestellt, dass das thermoelektrische Bauelement die vorteilhaften, durch die Faser erzeugten, Materialeigenschaften aufweist.

Das hier vorgeschlagene Verfahren ist durch die spezielle Anordnung einer mit thermoelektrischem Material beschichteten Faser gekennzeichnet. Durch diese Faser, insbesondere aus keramischem Material, wird die mechanische Festigkeit und Beständigkeit gegenüber thermischer Wechselbeanspruchung deutlich erhöht, so dass dauerfeste thermoelektrische Module bereitgestellt werden können. Insbesondere werden durch die mindestens eine Faser Kräfte in Umfangsrichtung der Ringe aufgenommen. Bevorzugt wird so ein Kriechen des thermoelektrischen Materials reduziert oder sogar vollständig verhindert.

Die Erfindung sowie das technische Umfeld werden nachfolgend anhand der Figuren näher erläutert. Die Figuren zeigen besonders bevorzugte Ausführungsbeispiele, auf die die Erfindung jedoch nicht begrenzt ist. Gleiche Bezugszeichen werden in den Figuren für gleiche Gegenstände verwendet. Es zeigen schematisch:
- Fig. 1:: eine Faser gemäß Schritt a) des Verfahrens,
- Fig. 2:: eine beschichtete Faser gemäß Schritt b) des Verfahrens,
- Fig. 3:: eine gewickelte, beschichtete Faser gemäß Schritt c) des Verfahrens in einer Draufsicht,
- Fig. 4:: eine gewickelte, beschichtete Faser gemäß Schritt c) des Verfahrens in einer Seitenansicht,
- Fig. 5:: ein thermoelektrisches Bauelement gemäß Schritt d) des Verfahrens,
- Fig. 6:: ein thermoelektrisches Bauelement gemäß Schritt d1) des Verfahrens, und
- Fig. 7:: ein Kraftfahrzeug (nicht Teil der Erfindung).

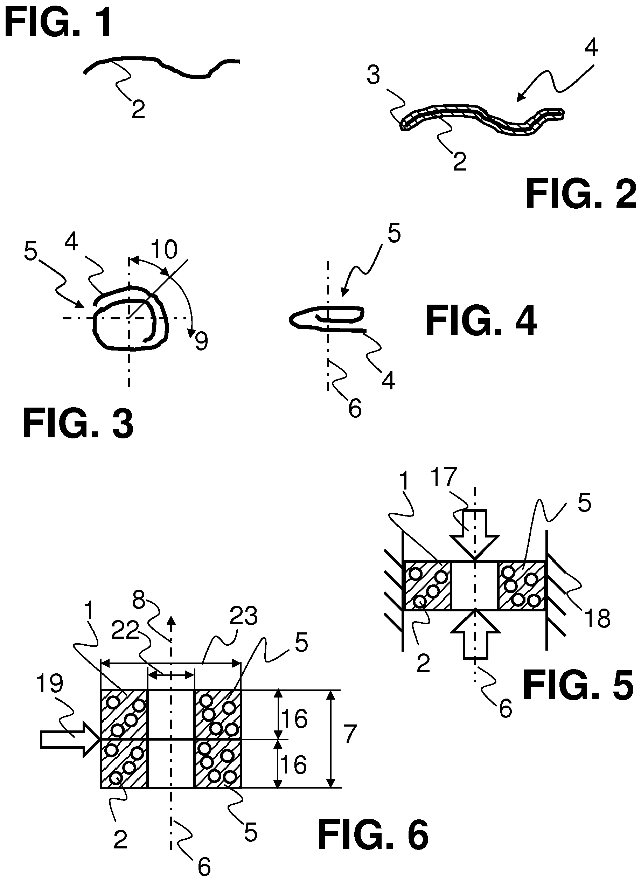

Fig. 1 zeigt die Bereitstellung einer Faser 2 gemäß Schritt a) des Verfahrens zur Herstellung eines thermoelektrischen Bauelements 1.

Fig. 2 zeigt eine beschichtete Faser 4, die hergestellt wurde gemäß Schritt b) des Verfahrens, wobei die Faser 2 mit einem thermoelektrischen Werkstoff 3 beschichtet wurde.

Fig. 3 zeigt die gewickelte, beschichtete Faser 4 gemäß Schritt c) des Verfahrens. Hier ist die gewickelte, beschichtete Faser 4 in einer Draufsicht gezeigt. Die beschichtete Faser 4 ist zu einem Ring 5 gewickelt, wobei sich die beschichtete Faser 4 in einer Umfangsrichtung 9 über einen Winkelbereich 10 erstreckt.

Fig. 4 zeigt die gewickelte, beschichtete Faser 4 gemäß Schritt c) des Verfahrens in einer Seitenansicht. Die beschichtete Faser 4 ist um eine Mittelachse 6 zu einem Ring 5 gewickelt.

Fig. 5 zeigt das thermoelektrische Bauelement 1, das gemäß Schritt d) des Verfahrens hergestellt wird. Der Ring 5 mit der Mittelachse 6 wird in einer Vorrichtung 18 durch zumindest eine Presskraft 17 zu einem thermoelektrischen Bauelement 1 verdichtet. In dem gezeigten Querschnitt des thermoelektrischen Bauelements 1 sind die Fasern 2 der beschichteten Fasern 4 zu erkennen.

Fig. 6 zeigt ein thermoelektrisches Bauelement 1 nach Schritt d1) des Verfahrens. Dabei wird ein thermoelektrisches Bauelement 1, das in Form eines Rings 5 vorliegt und sich entlang einer axialen Richtung 8 über eine erste Erstreckung 7 erstreckt, durch eine Trennung 19 in zwei thermoelektrische Bauelemente 1 geteilt. Diese thermoelektrischen Bauelemente 1 weisen nach der Trennung 19 jeweils eine kleinere zweite Erstreckung 16 auf. Das thermoelektrische Bauelement weist einen Innendurchmesser 22 und einen Außendurchmesser 23 auf.

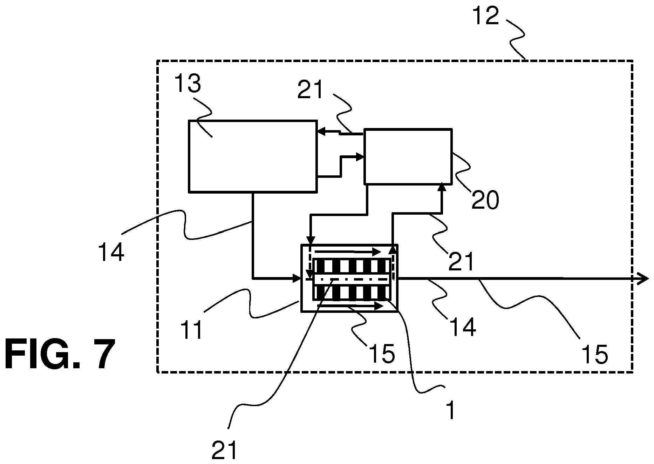

Fig. 7 zeigt ein Kraftfahrzeug 12 mit einer Verbrennungskraftmaschine 13 und einer Abgasanlage 14, wobei in der Abgasanlage 14 ein thermoelektrisches Modul 11 angeordnet ist. Ein Abgas 15 strömt ausgehend von der Verbrennungskraftmaschine 13 über die Abgasanlage 14 und das thermoelektrische Modul 11 an die Umgebung. Eine Kühlung 20 ist mit der Verbrennungskraftmaschine 13 und mit dem thermoelektrischen Modul 11 zur Kühlung verbunden. Ein kaltes Medium 21 strömt ausgehend von der Kühlung 20 hin zum thermoelektrischen Modul 11. Das thermoelektrische Modul 11 ist rohrförmig aufgebaut und weist ringförmige thermoelektrische Bauelemente 1 auf, die entlang einer axialen Richtung hintereinander angeordnet sind. Das thermoelektrische Modul 11 weist in einem inneren Kanal eine Kaltseite auf, die von dem kalten Medium 21 durchströmt wird. Die Heißseite ist hier auf der Außenfläche angeordnet. Auf der Außenfläche wird das thermoelektrische Modul 11 von dem Abgas 15 beaufschlagt. Es bildet sich entsprechend ein Temperaturpotential über das thermoelektrische Modul 11 zwischen Abgas 15 und kaltem Medium 21 aus, so dass durch die thermoelektrischen Bauelemente 1 ein elektrischer Strom erzeugt wird.

### Bezugszeichenliste

- 1: thermoelektrisches Bauelement
- 2: Faser
- 3: Thermoelektrischer Werkstoff
- 4: beschichtete Faser
- 5: Ring
- 6: Mittelachse
- 7: Erste Erstreckung
- 8: axiale Richtung
- 9: Umfangsrichtung
- 10: Winkelbereich
- 11: Thermoelektrisches Modul
- 12: Kraftfahrzeug
- 13: Verbrennungskraftmaschine
- 14: Abgasanlage
- 15: Abgas
- 16: Zweite Erstreckung
- 17: Presskraft
- 18: Vorrichtung
- 19: Trennung
- 20: Kühlung
- 21: Kaltes Medium
- 22: Innendurchmesser
- 23: Außendurchmesser

## Patentansprüche

1. Verfahren zur Herstellung eines thermoelektrischen Bauelements (1), aufweisend zumindest die folgenden Schritte:
a) Bereitstellen mindestens einer Faser (2),
b) Beschichten der mindestens einen Faser (2) mit einem thermoelektrischen Werkstoff (3), so dass mindestens eine beschichtete Faser (4) gebildet wird,
c) zumindest Wickeln der mindestens einen beschichteten Faser (4) zu einem Ring (5) mit einer Mittelachse (6), **gekennzeichnet durch**
d) Verpressen des Rings zur Erzeugung eines thermoelektrischen Bauelements, wobei
Das in Schritt d) erzeugte thermoelektrische Bauelement (1) eine erste Erstreckung (7) entlang einer axialen Richtung (8) aufweist und in einem Schritt d1) durch ein Trennverfahren in mehrere thermoelektrische Bauelemente (1) mit jeweils einer kleineren zweiten Erstreckung (16) in axialen Richtung (8) geteilt wird.

2. Verfahren nach Patentanspruch 1, wobei die mindestens eine beschichtete Faser (4) sich in einer Umfangsrichtung (9) des thermoelektrischen Bauelements (1) über einen Winkelbereich (10) von mindestens 120° erstreckt.

3. Verfahren nach einem der vorhergehenden Patentansprüche, wobei die mindestens eine Faser (2) aus einem keramischen Werkstoff besteht.

## Claims

1. Method for producing a thermoelectric component (1) having at least the following steps:
a) providing at least one fiber (2),
b) coating the at least one fiber (2) with a thermoelectric material (3) such that at least one coated fiber (4) is formed,
c) at least winding the at least one coated fiber (4) to form a ring (5) with a central axis (6), **characterized by**
d) compressing the ring to produce a thermoelectric component, wherein
the thermoelectric component (1) produced in step d) has a first extent (7) along an axial direction (8) and, in a step d1), is divided, by means of a separation process, into multiple thermoelectric components (1) each with a smaller, second extent (16) in the axial direction (8).

2. Method according to Patent Claim 1, wherein the at least one coated fiber (4) extends, in a circumferential direction (9) of the thermoelectric component (1), over an angle range (10) of at least 120°.

3. Method according to one of the preceding patent claims, wherein the at least one fiber (2) is composed of a ceramic material.

## Revendications

1. Procédé de fabrication d'un composant thermoélectrique (1) comprenant au moins les étapes suivantes :
a) fournir au moins une fibre (2),
b) revêtir ladite au moins une fibre (2) d'un matériau thermoélectrique (3) de manière à former au moins une fibre revêtue (4),
c) au moins enrouler ladite au moins une fibre revêtue (4) en un anneau (5) ayant un axe central (6), **caractérisé par** le fait de
d) presser l'anneau afin de produire un composant thermoélectrique, dans lequel
le composant thermoélectrique (1) produit lors de l'étape d) présente une première extension (7) le long d'une direction axiale (8) et, lors d'une étape d1), est divisé par un procédé de séparation en plusieurs composants thermoélectriques (1) présentant chacun une seconde extension (16) plus petite dans la direction axiale (8).

2. Procédé selon la revendication 1, dans lequel ladite au moins une fibre revêtue (4) s'étend dans une direction circonférentielle (9) du composant thermoélectrique (1) sur une plage angulaire (10) d'au moins 120°.

3. Procédé selon l'une des revendications précédentes, dans lequel ladite au moins une fibre (2) est constituée d'un matériau céramique.
